## Europäisches Patentamt
## European Patent Office
## Office européen des brevets

(19)

(11) Publication number: **0 190 855**
A2

(12) **EUROPEAN PATENT APPLICATION**

(21) Application number: **86300515.3**

(22) Date of filing: **27.01.86**

(51) Int. Cl.⁴: **H 01 L 31/02**
**H 01 L 31/06**

(30) Priority: **08.02.85 US 699523**
**08.02.85 US 699524**

(43) Date of publication of application:
**13.08.86 Bulletin 86/33**

(84) Designated Contracting States:
**CH DE FR GB IT LI NL**

(71) Applicant: ENERGY CONVERSION DEVICES, INC.
1675 West Maple Road
Troy Michigan 48084(US)

(72) Inventor: Nath, Prem.
245 Prospect avenue
Rochester Michigan 48063(US)

(72) Inventor: Barnard, Timothy J.
702 Kimberly, Apartment 201
Lake Orion Michigan 48035(US)

(72) Inventor: Crea, Dominic
37880 Maravian
Mt. Clemens Michigan 48043(US)

(74) Representative: Jackson, Peter Arthur et al,
GILL JENNINGS & EVERY 53-64 Chancery Lane
London WC2A 1HN(GB)

(54) Improved photovoltaic device tolerant of low resistance defects.

(57) An improved photovoltaic device (10, 10", 10"') exhibiting increased tolerance of low resistance defects includes a substrate (14) having a semiconductor body (12) disposed on it, a bus grid current collecting structure (22) disposed upon the semiconductor body and a transparent conductive electrode (32) overlying at least a portion of the semiconductor body. A layer of relatively high resistivity material (29, 29', 29") is disposed within the structure to restrict current from flowing directly between the substrate and the bus grid structure through a low resistance defect current path. The high resistivity layer may be disposed on the semiconductor body beneath the transparent electrode or on the substrate and in contact with the semiconductor body. In the former case, the transparent electrode may be interposed between the bus grid structure and high resistivity material or may be disposed on top of the bus grid structure. Preferably, the high resistivity layer is formed into a pattern corresponding to at least a portion of the bus grid structure and in registration with it.

FIG 1A

./...

FIG 1B

FIG. 1C

**0190855**

ENERGY CONVERSION DEVICES, INC.          Ref: 50/2851/02

### IMPROVED PHOTOVOLTAIC DEVICE
### TOLERANT OF LOW RESISTANCE DEFECTS

Thin film amorphous semiconductor materials offer several distinct advantages over crystalline materials. They can be easily and economically fabricated by newly developed mass production processes. However, in the fabrication of photovoltaic devices from amorphous semiconductor materials, low resistance defects frequently are produced. These defects seriously impair the performance of the photovoltaic devices and detrimentally affect production yield. These process-related defects are thought either to result from the morphology of the substrate electrode, or to develop during the deposition of the semiconductor layers. The invention is directed to eliminating or at least substantially reducing the effects of these current-shunting defects.

The most important of these defects may be characterized as "shunts", "short-circuits" or low resistance current paths. In a typical p-i-n type amorphous semiconductor photovoltaic device, the "p" layer may be only on the order of 25 nanometers thick, the "i" layer may be only on the order of 350 nanometers thick, and the "n" layer may be only on the order of 25 nanometers thick. The total semiconductor body thickness is therefore only about 400 nanometers. Even small irregularities in a substrate may not be covered by such thin semiconductor layers.

A photovoltaic device in which a shunt defect has developed exhibits either a lower power output, since electrical current collected at the electrodes flows through the defect region in preference to an external load, or complete failure where sufficient current flows through the defect region to "burn out" the device.

Under room light illumination, the load resistance of the cell (i.e., the resistance under which the cell is designed to operate most efficiently) is comparable to the shunt resistance (i.e., the internal resistance of the defect region). In bright sunlight, the load resistance is much lower than the shunt resistance. Under dim illumination the relatively small number of photogenerated current carriers flow through the path of least resistance, i.e., the low resistance defect regions. Under bright illumination, many more current carriers are present and are driven through the least resistance paths and elsewhere. Under high intensity illumination, more power is lost to the defect region, but the power lost is a smaller percentage of the total power produced than under low intensity illumination.

The highest quality stainless steel employed to serve as the substrate or base electrode upon which amorphous semiconductor layers are successively deposited has from 10,000 to 100,000 irregularities per square centimeter. Such irregularities take the form of projections, craters, or other deviations from a smooth finish and may be less than a micrometer in height or diameter. Regardless of their configuration or size, the defects may establish low resistance current paths through the semiconductor body in a photovoltaic device, effectively short-circuiting the device.

During the semiconductor deposition process, dust or other particulate matter may enter or be formed in the deposition apparatus. These contaminants may interfere with the uniform deposition of the semiconductor layers and may establish low resistance current paths within the semiconductor body. It is suspected that in some cases, the depositing semiconductor material may form micro-craters or micro-projections spontaneously, even in the absence of contaminants or pollutants from external sources.

The problems caused by undesired current shunting paths is solved in the invention by disposing a current flow restricting means within a photovoltaic device. The device includes a substrate, a semiconductor body disposed on the substrate, a layer of transparent electrically conductive material disposed opposite said substrate in electrical contact with at least a portion of the semiconductor body and a current collection means, such as a bus grid structure, disposed on the layer of transparent conductive material. The device includes an electrical current flow restricting material disposed on the semiconductor body between the transparent conductive layer and the substrate of the device. The current flow restricting material restricts the flow of electrical current between the current collection means and regions of the substrate and may be formed from a material chosen from the group consisting essentially of organic insulating materials, inorganic insulators, wide band gap semiconductors, silicones, cermets and combinations of them.

Figures 1A, 1B and 1C are fragmentary, cross-sectional views of tandem photovoltaic devices according to embodiments of the invention.

Figure 2 is a top plan view of an embodiment of a photovoltaic device according to the invention.

Figure 3 is a cross-sectional view of a portion of a photovoltaic device illustrating various types of defects therein.

Figure 4 is a top plan view of another embodiment of a photovoltaic device according to the invention, illustrating its bus grid structure.

Figure 5 is a cross-sectional view of an embodiment of a photovoltaic device according to the invention.

Figure 6 is a cross-sectional view of a photovoltaic device including a low resistance defect region.

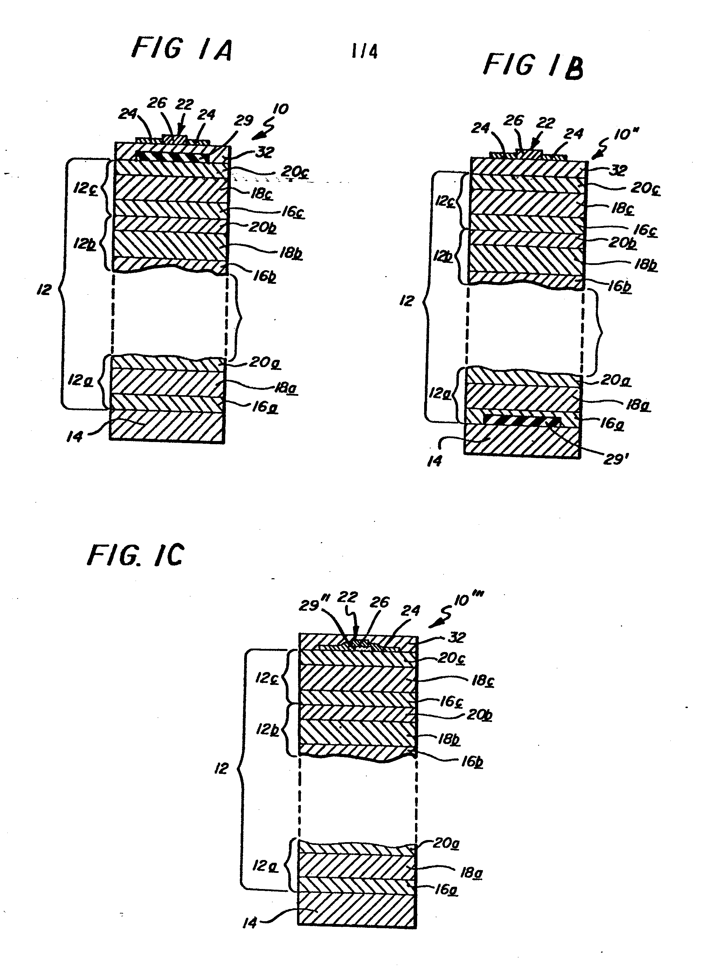

In the drawings like reference numbers designate like structure. Figures 1A, 1B and 1C show tandem photovoltaic devices, 10, 10'', 10''', respectively, each including a semiconductor body 12 consisting of a plurality of p-i-n photovoltaic cells 12a, 12b, and 12c. Below cell 12a is a substrate 14 that may be a metallic member such as an electrically conductive stainless steel sheet, or a thin metallic foil, or which may be formed from an electrically insulating material such as glass, plastic and the like with an electrically conductive member disposed on at least a portion of it.

Each of cells 12a, 12b and 12c includes a semiconductor body containing at least a silicon alloy. Each of the alloy bodies includes a p-type region or layer (16a, 16b and 16c); an intrinsic region or layer (18a, 18b and 18c); and an n-type region or layer (20a, 20b and 20c). Cell 12b is an intermediate cell and additional intermediate cells may be added to the illustrated cells without departing from the spirit or scope of the present invention. Also, although stacked p-i-n cells are illustrated, this invention is equally useful with single or stacked n-i-p cells.

The p-type layers, 16a, 16b and 16c, preferably have low light absorption and are of high conductivity. The intrinsic alloy layers, 18a, 18b and 18c, have an adjusted wavelength threshold for a solar photoresponse, high light absorption, low dark conductivity and high photoconductivity. The layers include sufficient amounts of a band gap adjusting element or elements to optimize the optical band gap for a particular cell application. Preferably, the intrinsic layers are band gap adjusted to provide cell 12a with a lowest band gap, cell 12c with the highest band gap, and cell 12b with a band gap between the other two. The n-type layers, 20a, 20b and 20c, have low light absorption and are of high conductivity. The thicknesses of the n-type, intrinsic and p-type layers are preferably in the range of about 2 to 50 nanometers 200 to 3000 and 2 to 50 nanometers, respectively.

Photovoltaic devices 10, 10'' and 10''' include a layer 32 of transparent electrically conductive material that serves as a top electrode of the photovoltaic device. Layer 32 is formed of indium tin oxide although other transparent conductive materials such as zinc oxide, cadmium stannate, tin oxide and indium oxide are known to skilled practitioners and may also be suitably employed to form the layer.

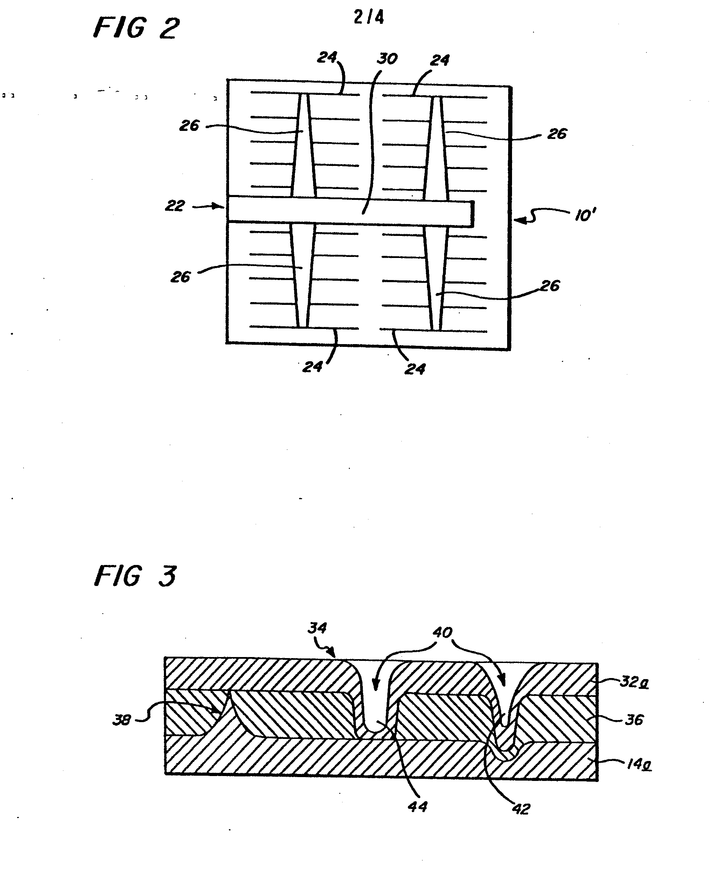

A bus grid structure 22 including a bus bar 26, having a plurality of current collecting grid fingers 24, is disposed in contact with layer 32. In Figure 2, a top plan view of a photovoltaic device 10', generally similar to the photovoltaic devices 10, 10'' and 10''' of Figures 1A, 1B and 1C, illustrates an embodiment of bus grid structure 22 more fully. Grid fingers 24 communicate directly with a plurality of minor bus bars 26 which in turn are connected to major bus bars 30, to carry photogenerated currents to a terminal of photovoltaic device 10'.

In the invention, the flow of currents through low resistivity paths directly from the substrate to the current collection bus grid structure is restricted by an interposed relatively high resistivity material. That material lengthens the current flow path from substrate to grid by adding a lateral portion to the path. Since in the devices described, the layers are very thin, there is a high resistance to lateral current flow. This added resistance discourages current flow along low resistance, defect paths.

The novel photovoltaic device includes a layer of electrical current flow restricting material disposed to prevent flow of electrical current to bus grid structure 22 from regions of the semiconductor body disposed directly beneath the grid structure. As illustrated in Figure 1A, in photovoltaic device 10, an electrical current flow restricting material 29 is disposed between the transparent conductive layer 32 and the surface of semiconductor body 12 opposite substrate 14. Preferably, current flow restricting material 29 is formed into a pattern that corresponds generally to at least portions of the pattern of bus grid structure 22. The patterns of bus grid structure 22 and current flow restricting material 29 are generally in registration, i.e. disposed in alignment with each other. Material 29 has a relatively low electrical conductivity. Organic insulators such as synthetic polymers, inorganic insulators such as silicon oxides, silicon nitride, alumina and the like, silicones, wide band gap semiconductors, cermets and combinations of them are suitable for use as current flow restricting material 29.

It is preferred that the pattern of current flow restricting material 29 correspond to at least the bus bar portion of the bus grid structure, although the pattern may also be advantageously configured to conform to grid fingers 24 also. It is preferred that the pattern of current flow restricting material cover an area slightly larger than the area covered by the superposed portion of the current collection means which it is protecting to give the greatest protection from low resistance defects. An excess in area of 10 to 15 percent is sufficient. It is preferred that the pattern of current flow restricting material have a sheet resistance greater than 300 ohms per square and preferably at least 1000 ohms per square.

The pattern may be formed by screen printing, vacuum evaporation, sputtering or plasma deposition. The appropriate pattern may be formed by depositing through a mask or by using known photolithographic patterning techniques. Electroplating, anodization, and electroless plating techniques may also be used, singly or in combination, to provide the low conductivity pattern.

In Figure 1B, another photovoltaic device 10'' embodying the invention is depicted. Photovoltaic device 10'' differs from photovoltaic device 10 in the location of the current flow restricting material. Material 29' is disposed between the substrate 14 and the first, or bottom most, surface of semiconductor body 12. Current flow restricting material 29' also restricts flow of current through defect regions. Bus grid structure 22 is in electrical communication with portions of semiconductor body 12 directly beneath it through layer 32. But those portions of the semiconductor body are not in direct electrical communication with corresponding subjacent portions of substrate 14 because of presence of material 29'. Again, bus grid structure 22 and material 29' have corresponding patterns, the patterns are generally in registration, and the pattern of material 29' has larger area than bus grid structure 22. Therefore, a direct short circuit path cannot be established between the bus grid structure and substrate electrode 14. The pattern of current flow restricting material 29' may be formed by any of the techniques described with reference to Figure 1A. When substrate 14 is formed of a metallic material, the pattern of insulating material 29' may be formed by anodizing, oxidizing or otherwise chemically treating that metal. For example, an electrically insulating pattern of alumina may be formed by anodizing an aluminum substrate, or an insulating coating may be formed on stainless steel by treatment with oxalic acid. In some cases, photovoltaic devices are formed on electrically insulating substrates such as polyimide coated metal, and an electrically conductive metallic pattern of base electrodes is provided on the insulating surface of the substrate via techniques such as vacuum deposition of metals. In such instances, the pattern of electrically insulating material 29' may be formed by not metallizing those portions of the insulating substrate that will form the insulating pattern. Alternatively, the metallization may be etched away to expose the underlying insulating surface of the substrate in a preselected pattern.

In Figure 1C, a photovoltaic device 10''' includes a bus grid structure 22 that is applied either directly to semiconductor body 12 or is separated from body 12, at least in part, by a layer 29'' of a relatively high resistivity material. In either event, transparent conductive layer 32 is deposited over bus grid structure 22. If a low resistance current path occurs in semiconductor body 12 between substrate 14 and grid 22, the current flowing in that path must travel laterally, through layer 32, to reach bus grid 22. That current flow is limited by the high resistance to the lateral current flow.

Low resistance current paths are illustrated in Figure 3 which depicts a portion of a photovoltaic device 34 including a substrate 14a, an active semiconductor body 36, and a transparent conductive layer 32a. One defect region exists adjacent a raised protuberance or spike 38 extending from the deposition surface of substrate 14a. The defect region formed in the immediate vicinity of the spike 38 provides a low resistance current path between conductive layer 32a and substrate 14a since its thickness is comparable to that of semiconductor body 36 which separates electrodes 14a and 32a. A second defect region exists in the immediate vicinity of craters 42 and 44. Crater 42 results from a substrate defect while crater 44 results from non-uniform deposition of semiconductor material 36. Transparent conductive material 32a is deposited at least partially in craters 40 and 42 establishing low resistance paths between substrate 14a and conductive layer 32a. A third type of defect (not shown) can arise in poor quality regions of the semiconductor body. These regions, which may be of improper composition or defective growth or morphology, exhibit low electrical resistivity relative to the remainder of the semiconductor body.

In addition to the defects existing as the result of substrate defects or defects in deposition processes, "operational mode failures," manifested by a sudden catastrophic inability of the photovoltaic device to function under normal operating conditions can occur. Operational mode failures are believed to result from a current or voltage driven reaction that intensifies latent defects in a photovoltaic device. It is also possible that electrode material may migrate across a defect site, such as crater 40 or protuberance 38. Even very slight electrode migration may be sufficient, over time, to establish a low resistivity current path through a defect site.

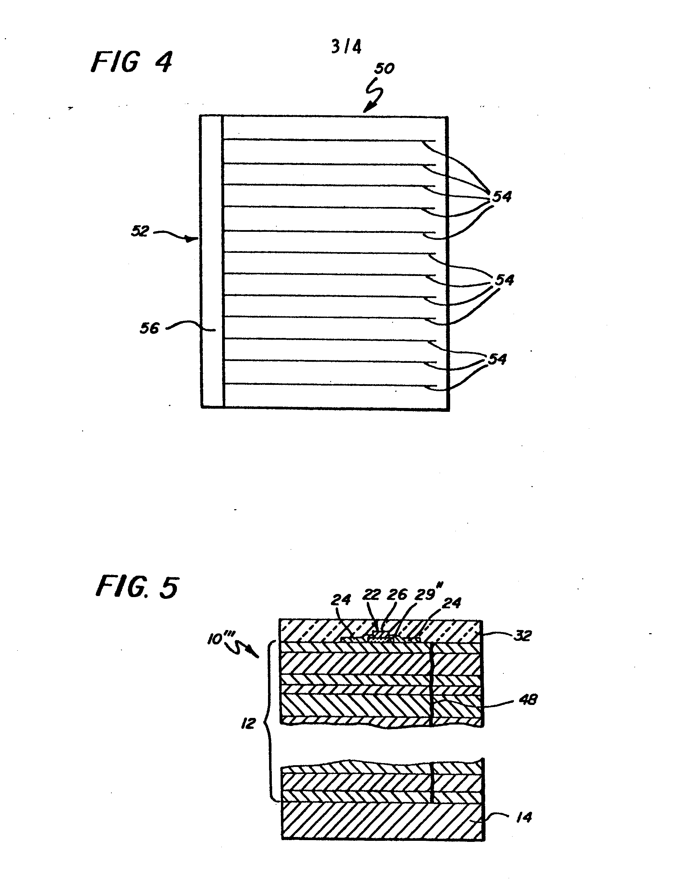

The present invention substantially prevents the free flow of electrical current through these defect regions to the bus grid structure regardless of the type of defect. Thus, the instant invention provides for a defect tolerant photovoltaic device. Figure 4, a top view, illustrates a large area photovoltaic device 50, including an embodiment of the invention. The device is generally similar to the photovoltaic devices 10, 10'' and 10''' of Figures 1A, 1B and 1C, except for bus grid structure 52 as the current collection means. Bus grid structure 52 comprises a plurality of minor bus bars 54 electrically communicating with a major bus bar 56. Minor bus bars 54 span the entire upper transparent electrode surface of photovoltaic device 50 to collect and carry photogenerated current to major bus bar 56. For tandem p-i-n photovoltaic devices similar to those described with reference to Figure 1 and provided with screen printed silver paste minor bus bars, a spacing of approximately .5 to 1.0 centimeters between minor bus bars 54 is sufficient to collect the photogenerated current efficiently. Major bus bar 56 is of higher current carrying capacity and generally of larger area than minor bus bars 54. In accordance with embodiments of the invention, a relatively high resistivity material is disposed on the semiconductor body beneath the transparent conductive top electrode of photovoltaic device 50. The high resistivity material is preferably disposed in a pattern corresponding to, in registration with and slightly larger than, overlying portions of bus grid structure 52. Photovoltaic devices such as that depicted in Figure 4 may be fabricated in extremely long lengths that may be cut to shorter lengths for particular applications..

Major bus bar 56 may be formed by adhesively affixing an electrically conductive member such as a copper foil to the surface of the device and minor bus bars 54 may be formed by screen printing a conductive paste. Alternatively, the minor bus bars may be formed by affixing metallic wires or tapes to the surface of the photovoltaic device with an electrically conductive adhesive. In still another method the entire bus bar structure may be formed by screen printing techniques. Electroplating, or electroless plating processes may also be employed to form the major and/or minor bus bars directly upon the surface of the photovoltaic device.

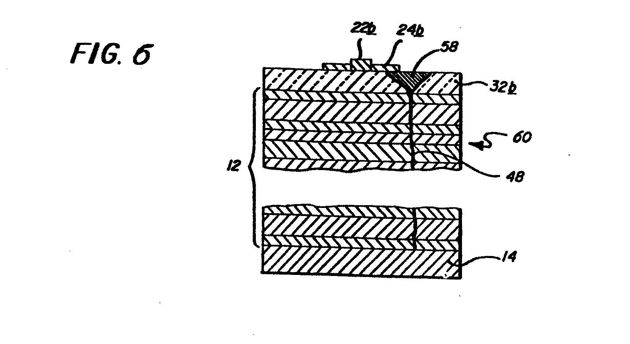

Figure 6 depicts a photovoltaic cell 60, generally similar to the cell 10''' depicted in Figure 1C with the exception that a bus grid pattern 22b is disposed on top of a transparent conductive electrode 32b. Other portions of photovoltaic cell 60 are similar to those depicted in Figure 1C for cell 10''' and will accordingly be referred to by similar reference numbers used in Figure 1C. Photovoltaic device 60 includes a defect region establishing a low resistance current path 48 from substrate electrode 14 through semiconductor body 12 to transparent conductive electrode 32b. Since the lateral resistivity of semiconductor body 12 is relatively high, current will preferentially flow along relatively narrow path 48. Electrical current flowing through current path 48 spreads when it reaches transparent conductive electrode 32b because the reduced lateral resistivity. This spreading increases the effective size of the defect region, as represented by the shaded region 58 depicted in Figure 6. In this manner, a defect not in direct alignment with portions of bus grid structure 22b may still electrically communicate readily with that structure. A short circuit between a portion of the bus grid and substrate electrode 14 will effectively short circuit the entire photovoltaic cell.

In Figure 5, photovoltaic cell 10''' of Figure 1C is depicted. Figure 5 shows a defect region that establishes a low resistivity current path 48 through semiconductor body 12. Because bus grid pattern 22 is disposed beneath transparent conductive electrode layer 32, electrical current flowing through path 48 will not readily reach the bus grid pattern. The resistivity of transparent conductive electrode layer 32 determines the degree of isolation of electrical current traveling through path 48. However, if upper electrode 32 is too resistive, the series resistance of the photovoltaic device is too large. Therefore the resistivity of the transparent conductive layer must be chosen to minimize the effect of short circuit paths without excessive loss in the collection of photogenerated current. A sheet resistance of approximately 150 ohms per square is preferred in a tandem p-i-n type photovoltaic cells formed of amorphous silicon and amorphous silicon:germanium alloy materials. Other values may be appropriate for differently configured cells or for cells fabricated of different semiconductor materials.

In another embodiment of the invention, a relatively high electrical resistivity layer 29'' is disposed beneath portions, or all, of bus grid structure 22. Layer 29'' restricts the current flow between directly opposed portions of bus grid structure 22 and semiconductor body 12. In this manner, low resistance current paths below layer 29'' are prevented from passing significant currents to overlying portions of bus grid structure 22. It is preferred that current flow restricting layer 29'' have a sheet resistance greater than 300 ohms per square and preferably a resistance of at least 1000 ohms per square.

Current flow restricting layer 29'' can be formed of electrical insulators such as silicon dioxide, silicon nitride, synthetic polymers and the like, as well as materials having relatively high electrical resistivity such as silicon carbide and other wide band gap semiconductors or cermets. In one embodiment of the invention, the upper layer of semiconductor body 12, for example the top most n-type layer of a p-i-n type cell, may form current flow restricting layer 29'', provided that the semiconductor layer has a sufficiently high electrical resistivity. In most instances, it is desirable to insulate at least major and minor bus bar portions 26 and 30 of Figure 2 from underlying semiconductor body 12 with layer 29'' to prevent short circuits. However, it is not preferred to isolate each of current collecting grid fingers 24 with such a current flow restricting layer. Where a low series resistance photovoltaic cell is desired, insulation of fingers 24 is not desired since it would require photocurrent generated in semiconductor body 12 to traverse a lateral path through transparent conductive electrode layer 32 to grid fingers 22.

The layers forming semiconductor body 12 may be deposited by any known method including sputtering, evaporation, glow discharge decomposition of a precursor gas, chemical vapor deposition.

CLAIMS

1. An improved photovoltaic device (10, 10'', 10''') tolerant of low resistance defects including: a substrate (14), a semiconductor body (12) having opposed first and second surfaces, said second surface being disposed on said substrate, an electrically interconnected bus grid structure (22, 52) having a pattern and disposed adjacent said first surface for collecting current generated in the photovoltaic device, characterized in that a layer of relatively high resistivity material (29, 29', 29'') is disposed on one of said first and second surfaces for restricting the flow of electrical current between at least a portion of said bus grid structure and the underlying portions of said semiconductor body, and, a transparent, electrically conductive layer (32) overlies at least a portion of said first surface in electrical contact with said bus grid structure.

2. The photovoltaic device (10) of claim 1 characterized in that said layer of relatively high resistivity material (29) is disposed between the transparent conductive layer and said first surface of the semiconductor body.

3. The photovoltaic device (10'') of claim 1 characterized in that said layer of relatively high resistivity material (29') is disposed between said second surface of the semiconductor body and said substrate.

4. The photovoltaic device (10''') of claim 1 characterized in that said layer of relatively high resistivity material (29'') is disposed between at least a portion of said pattern of said bus grid structure and said first surface of said semiconductor body.

5. The photovoltaic device of claim 4 characterized in that said transparent electrically conductive layer overlies substantially all of the semiconductor body and said pattern of said bus grid structure.

6.    The photovoltaic device of any one of the preceding claims characterized in that said layer of high resistivity material (29, 29', 29'') is formed into a pattern corresponding to and in registration with the pattern of said bus grid structure.

7.    The photovoltaic device of claim 6 characterized in that the area of said pattern of said relatively high resistivity material is approximately 10 to 15 percent larger than the area of the pattern of said bus grid structure.

8.    The photovoltaic device of any one of the preceding claims characterized in that said relatively high resistivity material is chosen from the group consisting essentially of: organic insulating materials, inorganic insulators, wide band gap semiconductors, silicones, cermets and combinations thereof.

9.    The photovoltaic device of any one of the preceding claims characterized in that said bus grid structure includes at least one bus bar (26, 56) and a plurality of grid fingers (24, 54) in electrical communication with said bus bar for collecting current generated in said photovoltaic device.

10.    The photovoltaic device of any one of the preceding claims characterized in that said layer of relatively high resistivity material comprises a portion of the semiconductor body.

# FIG 1A

# FIG 1B

# FIG. 1C

FIG 2

FIG 3

FIG 4

*50*

*52*

*56*

*54*

*54*

*54*

FIG. 5

*24* *22* *26* *29"* *24*

*10""*

*32*

*48*

*12*

*14*

4/4

FIG. 6